# EUROPÄISCHE PATENTANMELDUNG

(11) **EP 0 591 646 A2**
(43) Veröffentlichungstag der Anmeldung: **13.04.1994**
(21) Anmeldenummer: 93112862.3
(22) Anmeldetag: 11.08.1993
(51) Int. Cl.: H01L 21/337, H01L 21/338, H01L 29/808, H01L 29/812, H01L 21/335, H01L 29/76

(54) **Selbstjustierendes Verfahren zur Herstellung von Feldeffektransistoren**

(30) Priorität: 29.08.1992 DE 4228836
(71) Anmelder: Daimler-Benz Aktiengesellschaft, D-70546 Stuttgart (DE)
(72) Erfinder: Dickmann, Jürgen, Dr.-Ing., D-89079 Ulm-Einsingen (DE)
(74) Vertreter: Weber, Gerhard, Dipl.-Phys.

(57) **Zusammenfassung**

Es wird ein Verfahren zur Herstellung von Feldeffekttransistoren angegeben, bei dem ein r-förmiges Gate als Maske zur Herstellung der Source- und Drainkontakte verwendet wird. Durch das r-förmige Gate und Winkelbedampfung wird ein minimaler asymmetrische Source-Drain Abstand hergestellt. Durch eine derartige Strukturierung der Kontakte sind hohe Source-Drain Durchbruchspannungen und niederohmige Zuleitungen zu den Source und Drain Bereichen herstellbar.

## Beschreibung

Die Erfindung betrifft ein Verfahren zur Herstellung von Feldeffekttransistoren (FET) nach dem Oberbegriff des Patentanspruch 1.

Die Erfindung ist einsetzbar bei der Herstellung jeglicher Art von Feldeffekttransistoren.

Selbstjustierende Prozesse zur Herstellung von niederohmigen Source- und Drainkontakten unter Verwendung eines T-förmigen p⁺⁻Gate sind u.a. in einer Veröffentlichung von D. Wake et al., IEEE, EDL-5, NO. 7, 1984, S.285, beschrieben. Für die Herstellung von Höchstfrequenz-FET, die möglichst rauscharm sind, ist es jedoch notwendig, die Bahnwiderstände der Source- und Drain Zuleitungen weiter zu verringern, die Drain-Source Durchbruchspannungen zu erhöhen und die effektive Barrierenhöhe des FET zu erhöhen.

Der Erfindung liegt deshalb die Aufgabe zugrunde, ein Verfahren zur Herstellung von Hochleistungstransistoren anzugeben, mit dem niederohmige Source- und Drainkontakte, hohe Source- und Drain Durchbruchspannungen und große effektive Barrierenhöhen für beliebige FET herstellbar sind.

Die Aufgabe wird gelöst durch die im kennzeichnenden Teil des Patentanspruch 1 angegebenen Merkmale. Vorteilhafte Ausgestaltungen und/oder Weiterbildungen sind den Unteransprüchen zu entnehmen.

Die Erfindung wird anhand von Ausführungsbeispielen beschrieben unter Bezugnahme auf schematische Zeichnungen.

Die Erfindung hat den Vorteil, daß durch die speziell geformte Gate-Elektrode und die Verwendung dieser Gate-Elektrode als Maske für die Herstellung-der Source- und Drainkontakte sehr geringe Drain-Source Abstände einstellbar sind. Ein weiterer Vorteil liegt in der Herstellung von asymmetrischen Source-Drain Abständen, da dadurch höhere Durchbruchspannungen erzielbar sind.

Die Verwendung einer graduell gestuft dotierten Deckschicht für einen FET, auf die die ohmschen Kontakte aufgebracht werden, trägt zu einer weiteren Verringerung der Bahnwiderstände und der Rückkoppelkapazität zwischen Gate und Drain bei.

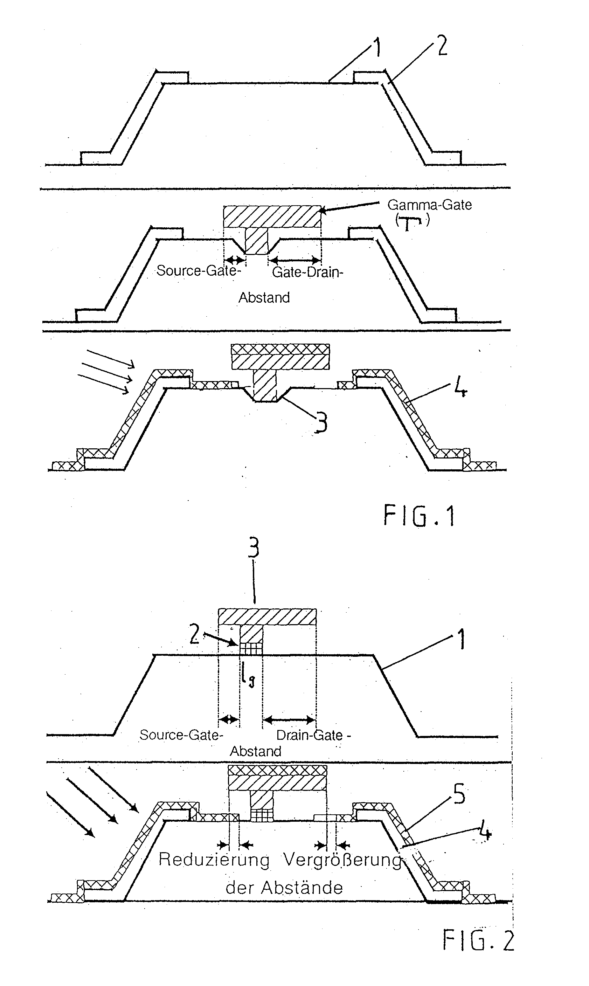

In Fig. 1 ist ein Herstellungsverfahren für eine Gate-Elektrode eines Schottky-Kontaktes dargestellt. Auf die mesageätzte Oberfläche 1 des FET wird eine erste Metallschicht 2 aufgebracht, in der ein Fenster für den Gate-Bereich geöffnet wird. Die Gate-Position wird durch Ätzen eines Recessgrabens 3 festgelegt. Anschließend wird ein r-förmiges Gate hergestellt, derart, daß der obere Teil des Gate asymmetrisch in Richtung Drain verschoben ist. Durch Winkelbedampfen mit Metall wird eine zweite Metallschicht 4 abgeschieden und es werden ohmsche Kontakte hergestellt. Dabei besitzt der Source-Kontakt einen weitaus geringeren Abstand zum Gate als der Drain-Kontakt. Durch einen derartigen asymmetrischen Abstand wird die Source-Drain Durchbruchspannung erhöht und gleichzeitig die Rückkoppelkapazität zwischen Gate und Drain reduziert. Insgesamt ist der Drain-Source Abstand sehr klein, so daß die Bahnwiderstände der Zuleitungen im Source- und Draingebiet niederohmig sind.

In Fig. 2 ist die Herstellung eines Gate mit p⁺⁻n Übergang dargestellt. Auf einer z.B. mesageätzten FET-Struktur 1 wird eine p⁺⁻dotierte Halbleiterschicht 2 auf die n-dotierte Deckschicht des FET aufgewachsen. Die Dotierung und die Schichtdicke der p⁺⁻dotierten Halbleiterschicht 2 sind so gewählt, daß der Abstand zwischen Gate und dem Kanal sowie der effektive Randquerschnitt optimal eingestellt sind. Beispielsweise besteht die Deckschicht des FET aus einer n-dotierten InGaAs-Schicht, mit einer Schichtdicke von 20 nm und einer Dotierstoffkonzentration von 2·10¹⁸ cm-³. Die p⁺⁻dotierte Halbleiterschicht 2 besitzt eine Schichtdicke von ca. 10 nm und eine Dotierstoffkonzentration von 10¹⁹ cm-³. Anschließend wird ein r-förmiges Gate 3 auf der p⁺⁻dotierten Halbleiterschicht 2 hergestellt mit einem in Richtung Drain verlängertem Oberteil. Die Gate-Länge I_{g} wird durch gezieltes Unterätzen der p⁺⁻dotierten Halbleiterschicht 2 eingestellt. Die p⁺⁻dotierte Halbleiterschicht 2 verbleibt lediglich unter dem Metall-Gate. Anschließend werden die ohmschen Kontakte hergestellt, indem die entsprechenden Metallschichten 4,5 aufgedampft werden. Dabei dient das r-förmige Gate als Maske. Durch Winkelbedampfen wird zusätzlich noch eine Verschiebung der Source-Gate und Gate-Drain Abstände erreicht, derart, daß ein sehr geringer Source-Gate Abstand und ein relativ großer Gate-Drain Abstand entsteht. Um niederohmige Kontakte herstellen zu können, ist es außerdem vorteilhaft, die Deckschicht des FET graduell gestuft zu dotieren, derart, daß an der Oberfläche der Deckschicht eine hohe Dotierstoffkonzentration vorhanden ist und die Dotierung mit wachsender Schichtdicke abnimmt. Beispielsweise ist es für einen aus InAlAs/InGaAs Material aufgebauten FET mit Schottky-Gate vorteilhaft, eine Deckschicht aus InGaAs zu verwenden, deren Dotierstoffkonzentration an der Oberfläche 10¹⁹ cm-³ beträgt und etwa bis zur Hälfte der Schichtdicke der Deckschicht auf 5.1017 cm-³ abnimmt.

Für ein Schottky-Gate ist es weiterhin vorteilhaft, daß eine hohes Barrierenpotential vorhanden ist. Dies wird erreicht durch eine unterhalb der Deckschicht angeordnete Barriereschicht, die z.B. für einen aus InAlAs/InGaAs aufgebauten FET aus eine InAIAs-Schicht besteht.

Die Erfindung ist nicht auf die in den Ausführungsbeispielen angegebenen Materialien beschränkt, sondern generell für alle Arten von FET geeignet.

## Patentansprüche

1. Verfahren zur Herstellung von Feldeffekttransistoren unter Verwendung eines selbstjustierenden Prozesses zur Einstellung des Source-Drain Abstandes, dadurch gekennzeichnet,
- daß die Gate-Elektrode r-förmig ausgebildet wird, und
- daß eine Metallschicht zur Herstellung der Source- und Drainkontakte durch Winkelbedampfung aufgebracht wird, wobei das r-geformte Gate als Maske zur Herstellung eines geringen Source-Drain Abstandes verwendet wird.

2. Verfahren nach Anspruch 1, dadurch gekennzeichnet, daß ein Schottky-Gate durch folgende Prozeßschritte hergestellt wird:
- Aufbringen einer ersten Metallisierungsschicht auf einer Bauelementschichtenfolge eines FET, derart, daß der Gate-Bereich freiliegt
- Ätzen eines Recessgrabens zur Positionierung des Gate
- Herstellen eines r-förmigen Gate, dessen Oberteil in Richtung Gate verlängert ist
- Aufbringen einer zweiten Metallschicht durch Winkelbedampfen, derart, daß ein sehr kleiner Source-Gate Abstand und ein vergrößerter Gate-Drain Abstand erzeugt wird.

3. Verfahren nach Anspruch 1, dadurch gekennzeichnet, daß ein p^{l-}Gate durch folgende Prozeßschritte hergestellt wird:
- Aufwachsen einer p⁺⁻dotierten Halbleiterschicht auf einer Bauelementschichtenfolge eines FET
- Aufbringen des Gate-Metalls auf der p⁺⁻ dotierten Halbleiterschicht und Strukturierung eines r-förmigen Gate
- Unterätzen der p⁺⁻dotierten Halbleiterschicht
- Aufbringen von Metallschichten durch Winkelbedampfen, derart, daß ein sehr kleiner Source-Gate Abstand und ein vergrößerter Gate-Drain Abstand erzeugt wird.

4. Verfahren nach einem der vorhergehenden Ansprüche, dadurch gekennzeichnet,
- daß die obersten Schichten der Halbleiterschichtenfolge des FET aus einer Barriere- und einer Deckschicht gebildet werden, und daß die Deckschicht graduell gestuft dotiert wird.

5. Verfahren nach Anspruch 4, dadurch gekennzeichnet,
- daß einem InP-Substrat eine InAlAs/InGaAs Schichtenfolge aufgewachsen wird,
- daß die Barriere- und die Deckschicht aus InGaAs hergestellt werden, und
- daß die Deckschicht derart dotiert wird, daß die Deckschicht an der Oberfläche eine hohe n-Dotierung besitzt, die mit wachsender Schichtdicke abnimmt.

6. Verfahren nach den Ansprüchen 3 bis 5, dadurch gekennzeichnet, daß die p⁺⁻dotierte Halbleiterschicht aus InGaAs hergestellt wird.
